(19) Europäisches Patentamt
European Patent Office
Office européen des brevets

(11) **EP 4 075 156 A1**

(12) **DEMANDE DE BREVET EUROPEEN**

(43) Date de publication:
**19.10.2022 Bulletin 2022/42**

(51) Classification Internationale des Brevets (IPC):
**G01R 33/032** *(2006.01)* **G01R 33/00** *(2006.01)*

(21) Numéro de dépôt: **22167193.6**

(52) Classification Coopérative des Brevets (CPC):
**G01R 33/032; G01R 33/0017; G01R 33/0041**

(22) Date de dépôt: **07.04.2022**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
Etats de validation désignés:
**KH MA MD TN**

(30) Priorité: **16.04.2021 FR 2103981**

(71) Demandeurs:
• **Commissariat à l'énergie atomique et aux énergies alternatives**
**75015 Paris (FR)**

• **Centre National d'Etudes Spatiales**
**75001 Paris (FR)**

(72) Inventeurs:
• **JAGER, Thomas**
**38054 GRENOBLE CEDEX 09 (FR)**
• **BERTRAND, François**
**38054 GRENOBLE CEDEX 09 (FR)**

(74) Mandataire: **Brevalex**
**95, rue d'Amsterdam**
**75378 Paris Cedex 8 (FR)**

(54) **PROCÉDÉ D EXPLOITATION D'UN MAGNÉTOMÈTRE A POMPAGE OPTIQUE CHAMP NUL OPÉRÉ DANS UN CHAMP AMBIANT NON NUL**

(57) L'invention porte sur un procédé de démarrage d'un magnétomètre (20) soumis à un champ magnétique ambiant dont la projection sur trois axes de coordonnées rectangulaires en définit trois composantes, le magnétomètre comprenant :
- une source optique (2, 3) qui émet en direction d'une cellule (1) remplie d'un gaz atomique un faisceau de pompe,
- un photodétecteur (6) qui fournit un signal électrique représentatif de l'absorption du faisceau de pompe par la cellule ;

-un circuit de génération de champ (7) pouvant être piloté pour générer un champ magnétique dans la cellule.
Le procédé comprend, pour chaque axe desdits trois axes, les étapes de :
- pilotage du circuit de génération de champ pour qu'il réalise un balayage de champ suivant l'axe ; et de
- détermination de la composante du champ magnétique ambiant suivant l'axe à partir du signal électrique délivré par le photodétecteur au cours du balayage de champ suivant l'axe.

FIG. 3

EP 4 075 156 A1

**Description**

**DOMAINE TECHNIQUE**

Le domaine de l'invention est celui des magnétomètres à pompage optique qui utilisent les signaux de résonances paramétriques en champ nul pour pouvoir effectuer une mesure vectorielle du champ magnétique ambiant. L'invention concerne plus particulièrement une procédure de démarrage d'un tel magnétomètre dans un champ magnétique ambiant qui ne se situe pas dans la zone d'opérabilité définie par les caractéristiques des signaux de résonances paramétriques en champ nul.

**TECHNIQUE ANTÉRIEURE**

Les magnétomètres à pompage optique dits « champ nul » (capteurs dont l'élément sensible est à base d'hélium-4 ou à base d'alcalins tels que le césium ou le rubidium), dont un exemple de réalisation est décrit dans la demande de brevet FR 3 093 816 A1, utilisent les signaux de résonances paramétriques en champ nul pour pouvoir effectuer une mesure vectorielle du champ ambiant.

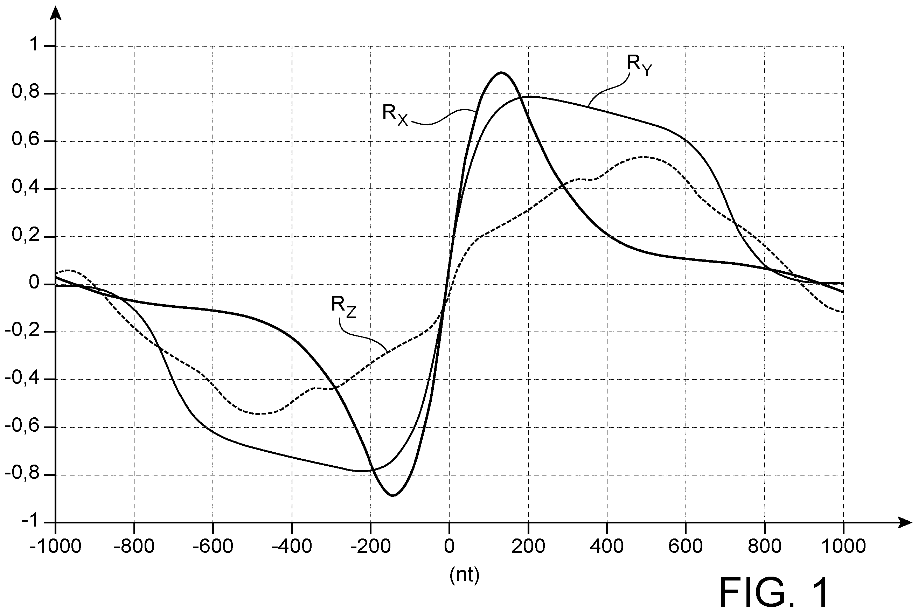

Une illustration de ces signaux de résonances paramétriques est donnée sur la figure 1 pour un capteur à base d'hélium-4 plongé dans un environnement proche du champ nul, où les signaux Rx, Ry et Rz correspondent aux signaux de résonances observés lors de balayages de champ sur chacun des trois axes d'un repère attaché au capteur dans une gamme d'amplitudes comprises entre -1 $\mu$T et +1 $\mu$T.

Ces signaux de résonance permettent d'effectuer une mesure des composantes du champ magnétique dans le repère du capteur lorsque le champ ambiant est très faible. On utilise en effet le caractère impair de ces signaux en configuration boucle ouverte (la mesure directe de l'amplitude du signal sur la zone linéaire autour du « 0 » est directement reliée au champ sur l'axe d'intérêt) ou en configuration boucle fermée (en compensant le champ ambiant sur le ou les axes d'intérêts afin de rester sur le « 0 » des courbes de résonance utilisées alors comme signaux d'asservissement du ou des champs de compensation).

Cependant, ces signaux de résonance ne sont exploitables que dans un environnement où le champ ambiant reste proche du champ nul, c'est-à-dire dans le cas où les composantes vectorielles du champ ambiant dans le repère du capteur se situent, dans le cas le cas de l'hélium-4, dans une zone de l'ordre de +/- 100 nT autour de « 0 » (l'amplitude de cette zone varie en fonction de l'élément sensible et dépend de différentes caractéristiques liées à l'élément sensible et à sa mise en en œuvre pour exciter les résonances paramétriques en champ nul).

C'est en général le cas dans les principaux domaines de développement et d'utilisation de ces capteurs, en magnétoencéphalographie ou en magnétocardiographie par exemple, où les capteurs sont utilisés dans des blindages magnétiques qui atténuent alors très significativement les composantes statiques du champ magnétique terrestre dans l'environnement de la mesure.

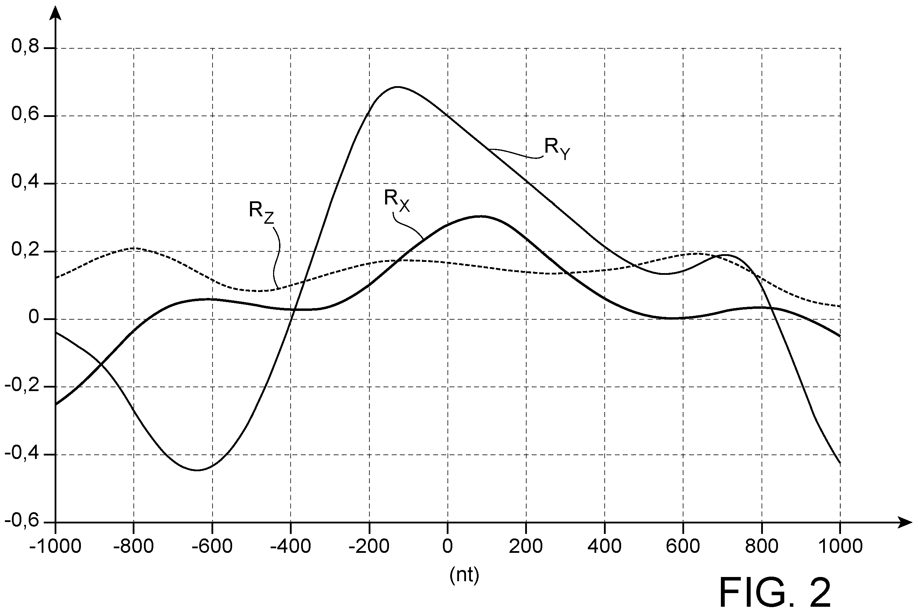

Mais dès que le champ ambiant vu par l'élément sensible du capteur se situe hors des caractéristiques de cette zone de champ nul, par exemple dans l'environnement terrestre (champ magnétique d'intensité entre 15 et 65 $\mu$T à la surface de la Terre), il n'est plus possible de démarrer et d'asservir ces capteurs en utilisant les résonances paramétriques en champ nul car les caractéristiques des signaux de résonance sont trop affectées par le champ ambiant : indétermination du point de fonctionnement des asservissements du fait de la présence de plusieurs « 0 », modification du signe de la pente du signal d'asservissement, etc. Ce comportement est illustré à titre illustratif sur la Figure 2 où sont représentés les signaux de résonances paramétriques Rx, Ry et Rz cette fois-ci dans un environnement où le champ ambiant n'est plus nul mais présente une valeur de 500 nT sur chacun des trois axes du repère d'un capteur hélium-4. On constate aisément les modifications par rapport aux signaux représentés sur la Figure 1.

**EXPOSÉ DE L'INVENTION**

Un objectif de l'invention est de rendre lpossible le démarrage d'un magnétomètre à résonances paramétriques plongé dans un c; hamp magnétique ambiant qui se situe hors de la zone d'opérabilité donnée par les caractéristiques des signaux de résonances paramétriques en champ nul.

Pour ce faire, l'invention propose un procédé d'exploitation d'un magnétomètre soumis à un champ magnétique ambiant dont la projection sur trois axes de coordonnées rectangulaires en définit trois composantes. Le magnétomètre comprend :

- une source de pompage optique agencée pour émettre en direction d'une cellule remplie d'un gaz atomique un faisceau de lumière accordé sur une transition atomique ;
- un photodétecteur agencé pour détecter le faisceau de lumière ayant traversé la cellule et délivrer un signal électrique représentatif de l'absorption du faisceau de lumière par la cellule ;

- un circuit de génération de champ pouvant être piloté pour générer un champ magnétique dans la cellule.

Le procédé comporte une phase de démarrage du magnétomètre qui comprend, pour un premier axe desdits trois axes, les étapes de :

- pilotage du circuit de génération de champ pour qu'il réalise un balayage de champ suivant le premier axe en venant générer un champ magnétique de recherche suivant le premier axe et faire varier l'amplitude dudit champ magnétique de recherche pour balayer une gamme d'amplitudes ; et de
- détermination de la composante du champ magnétique ambiant suivant le premier axe à partir du signal électrique délivré par le photodétecteur au cours du balayage de champ suivant le premier axe.

Certains aspects préférés mais non limitatifs de ce procédé sont les suivants :

- la phase de démarrage comprend, suite à la détermination de la composante du champ magnétique ambiant suivant le premier axe, le pilotage du circuit de génération de champ pour qu'il génère un premier champ magnétique de compensation opposé à la composante du champ magnétique ambiant suivant le premier axe et la réitération desdites étapes de pilotage et de détermination en substituant audit premier axe un deuxième axe desdits trois axes ;
- la phase de démarrage comprend, suite à la détermination de la composante du champ magnétique ambiant suivant le deuxième axe, le pilotage du circuit de génération de champ pour qu'il génère le premier champ magnétique de compensation et un deuxième champ magnétique de compensation opposé à la composante du champ magnétique ambiant suivant le deuxième axe et la réitération desdites étapes de pilotage et de détermination en substituant audit deuxième axe un troisième axe desdits trois axes ;
- la phase de démarrage comprend en outre, au cours du balayage de champ suivant le premier axe, le pilotage du circuit de génération de champ pour qu'il génère un champ statique additionnel suivant le troisième axe ;
- le balayage de champ suivant le premier axe est réitéré avec un champ statique additionnel suivant le troisième axe de direction opposée ;
- la phase de démarrage comprend en outre, au cours du balayage de champ suivant le deuxième axe, le pilotage du circuit de génération de champ pour qu'il génère un champ statique additionnel suivant le troisième axe ;
- le balayage de champ suivant le deuxième axe est réitéré avec un champ statique additionnel suivant le troisième axe de direction opposée ;
- la phase de démarrage comprend en outre, au cours du balayage de champ suivant le troisième axe, le pilotage du circuit de génération de champ pour qu'il génère un champ statique additionnel suivant l'un des premier et deuxième axes ;
- la phase de démarrage comprend en outre, suite à la détermination de la composante du champ magnétique ambiant selon le troisième axe, une étape de pilotage du circuit de génération de champ pour qu'il génère ledit premier champ magnétique de compensation, ledit deuxième champ magnétique de compensation et un troisième champ magnétique de compensation opposé à la composante du champ magnétique ambiant suivant le troisième axe ;
- il comprend, à l'issue de la phase de démarrage, une phase de fonctionnement au cours de laquelle le circuit de génération de champ est asservi par un circuit de détection de résonances paramétriques pour assurer un fonctionnement en champ nul du magnétomètre.

L'invention porte également sur un magnétomètre destiné à la mesure d'un champ magnétique ambiant dont la projection sur trois axes de coordonnées rectangulaires en définit trois composantes, comprenant :

- une source de pompage optique agencée pour émettre en direction d'une cellule remplie d'un gaz atomique un faisceau de lumière accordé sur une transition atomique ;
- un photodétecteur agencé pour recevoir le faisceau de lumière ayant traversé la cellule et configuré pour délivrer un signal électrique représentatif de l'absorption du faisceau de lumière par la cellule ;
- un circuit de génération de champ apte à être piloté pour générer un champ magnétique dans la cellule.

Le magnétomètre comporte en outre :

- un circuit de pilotage du circuit de génération de champ, ledit circuit de pilotage étant configuré pour que le circuit de génération de champ réalise un premier balayage de champ en venant générer un champ magnétique de recherche selon un premier axe desdits trois axes et faire varier l'amplitude dudit champ magnétique de recherche pour balayer une première gamme d'amplitudes ; et
- un circuit de détermination d'une composante du champ magnétique ambiant selon le premier axe à partir du signal électrique délivré par le photodétecteur au cours du premier balayage de champ.

## BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :

- [Fig. 1] déjà discutée précédemment, représente des signaux de résonances paramétriques observés lors de balayages de champ sur chacun des trois axes d'un repère attaché à un capteur hélium-4 plongé dans un environnement proche du champ nul ;
- [Fig. 2] déjà discutée précédemment, représente des signaux de résonances paramétriques observés lors de balayages de champ sur chacun des trois axes d'un repère attaché à un capteur hélium-4 plongé dans un environnement qui se situe en dehors des conditions de champ nul ;
- [Fig. 3] est un schéma d'un magnétomètre dans lequel peut être mis en œuvre le procédé selon l'invention ;
- [Fig. 4]

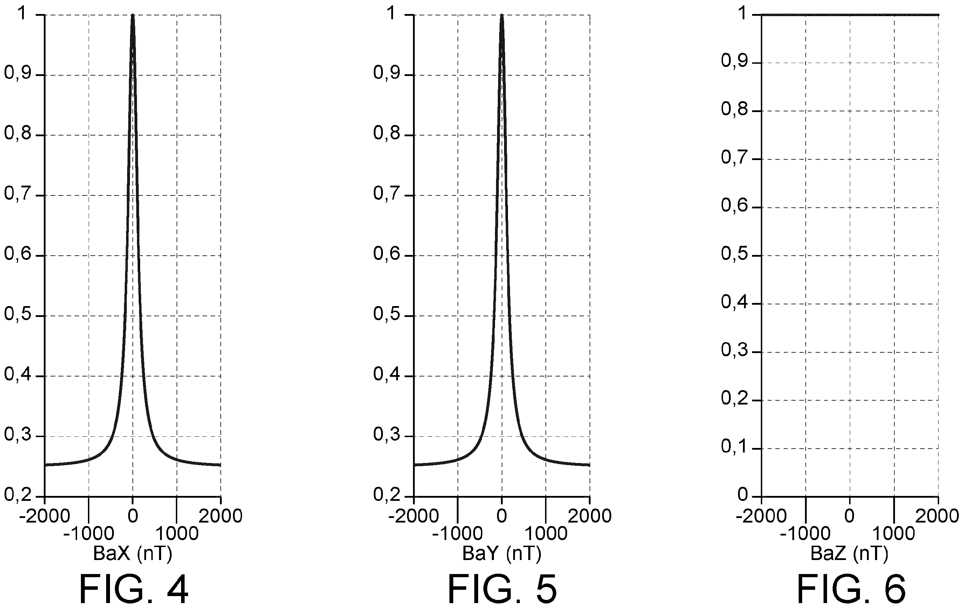

- [Fig. 5], et
- [Fig. 6] représentent des signaux de résonance Hanle observés au cours de balayages successifs sur chacun des trois axes d'un capteur plongé dans un champ ambiant nul ;
- [Fig. 7]

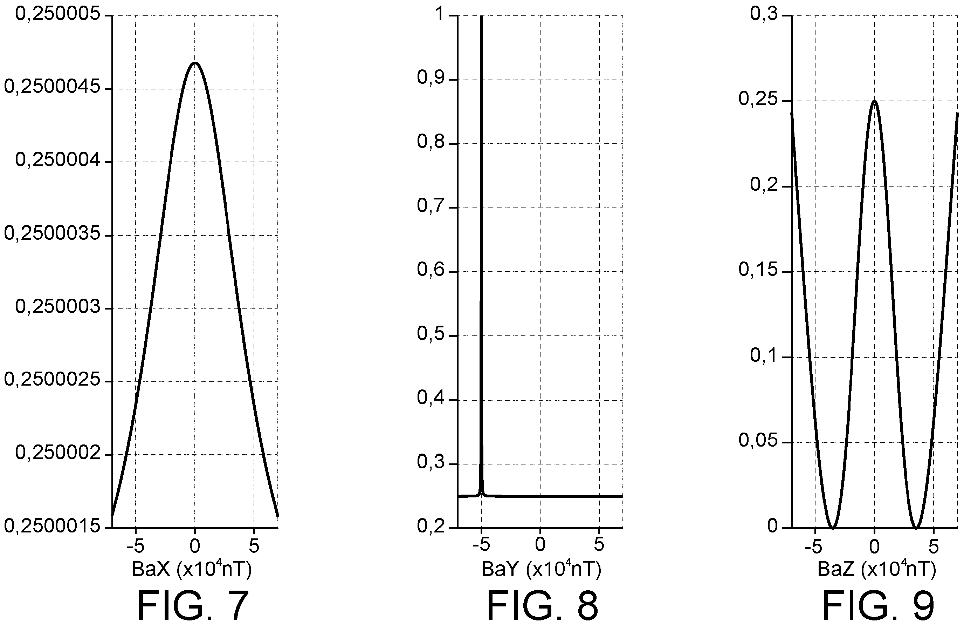

- [Fig. 8], et
- [Fig. 9] représentent des signaux de résonance Hanle observés au cours de balayages successifs sur chacun des trois axes d'un capteur plongé dans un champ ambiant non nul ;

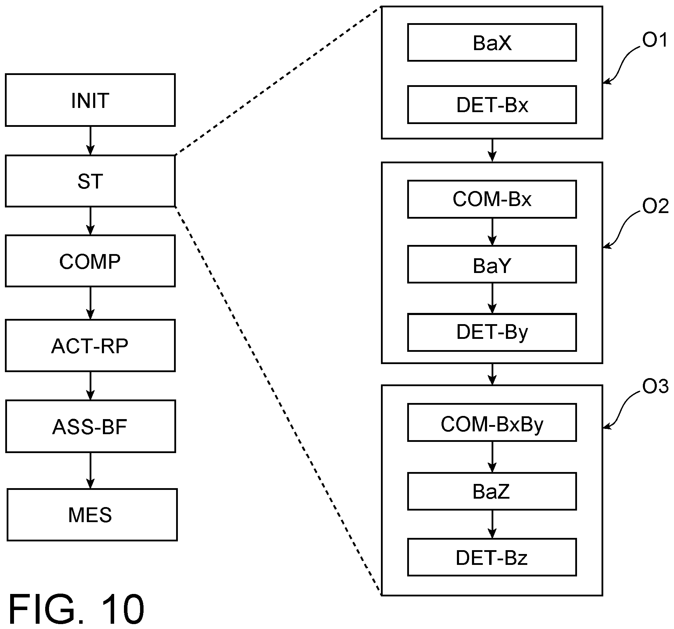

- [Fig. 10] est un organigramme d'un procédé selon un mode de réalisation possible de l'invention ;

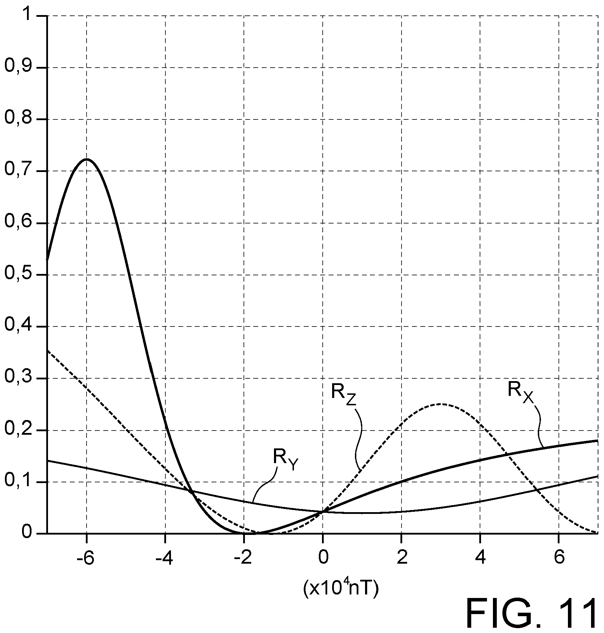

- [Fig. 11] représente l'évolution de signaux de résonance Hanle observés au travers de balayages de champ effectués sur chacun des axes d'un capteur plongé dans un champ ambiant de [60 ; -10 ; -30] $\mu$T ;
- [Fig. 12]

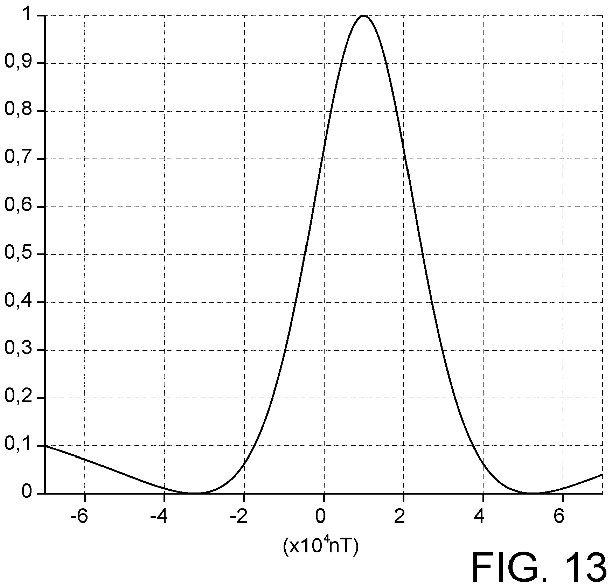

- [Fig. 13], et

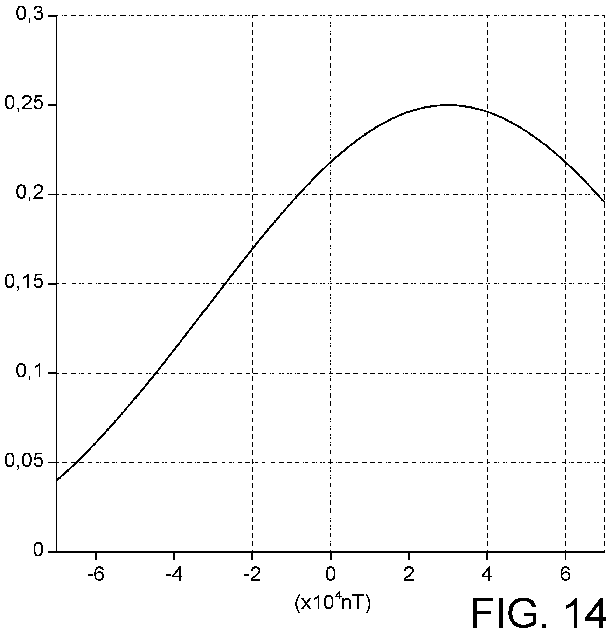

- [Fig. 14] illustrent l'évolution des signaux de résonance Hanle observés au travers de balayages de champ effectués sur chacun des axes d'un capteur plongé dans un champ ambiant de [60 ; -10 ; -30] $\mu$T conformément à un exemple de réalisation de l'invention.

## EXPOSE DETAILLE DE MODES DE REALISATION PARTICULIERS

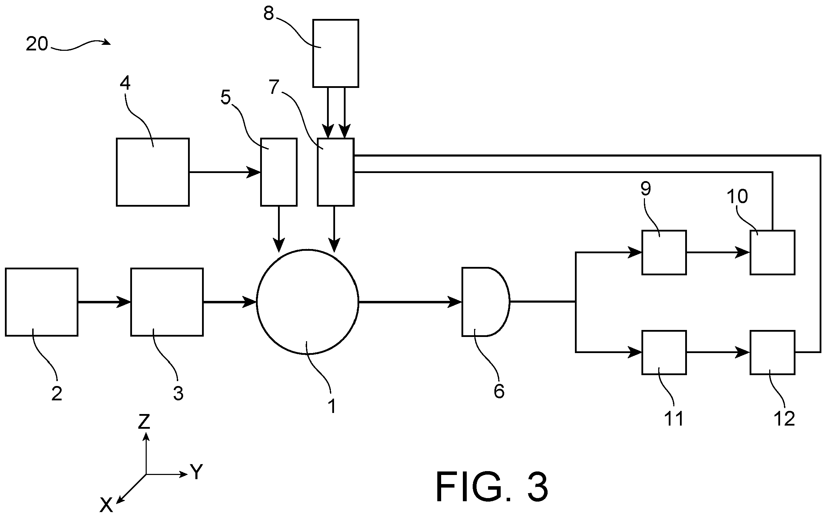

En référence à la figure 3, l'invention porte sur un magnétomètre vectoriel à pompage optique 20 qui comprend une cellule 1 remplie d'un gaz atomique, par exemple de l'hélium-4 ou un gaz alcalin, soumis à un champ magnétique ambiant dont la projection sur trois axes de coordonnées rectangulaires X, Y, Z en définit trois composantes. Le champ magnétique ambiant se décompose ainsi en trois composantes Bx, By et Bz chacune selon l'un des axes de mesure du magnétomètre X, Y et Z.

La cellule est éclairée par une source de pompage optique 2, 3 agencée pour émettre en direction de la cellule 1 un faisceau de lumière, par exemple un faisceau laser, accordé à une longueur d'onde de pompage (ce faisceau est ainsi également désigné par faisceau de pompe). La longueur d'onde de pompage est calée sur une raie de transition atomique, par exemple sur la raie $D_0$ à 1083 nm dans le cas de l'hélium-4. Le faisceau de lumière peut être émis par une source laser 2 et être polarisé linéairement au moyen d'un polariseur rectiligne 3 intercalé entre la source laser 2 et la cellule 1 ou directement intégré à la source laser 2. Le faisceau de lumière se propage selon une direction de propagation confondue avec l'axe Y et est polarisé linéairement selon l'axe Z. L'invention n'est toutefois pas limitée à une polarisation linéaire de faisceau de pompe mais s'étend également une polarisation circulaire du faisceau de pompe.

Dans le cas où l'élément sensible est l'hélium-4, le magnétomètre 20 comporte par ailleurs un système de décharge haute fréquence (HF), comprenant un générateur HF 4 et un système d'électrodes placées autour de la cellule 5, pour amener les atomes du gaz atomique dans un état énergisé où ils sont aptes à subir la transition atomique lorsqu'ils sont éclairés par le faisceau de lumière, typiquement dans l'état métastable $2^3S_1$.

Le magnétomètre 20 comprend également un circuit d'excitation de résonances paramétriques qui comporte un générateur de radiofréquence 8 qui alimente des bobines 7 d'axes orthogonaux qui entourent la cellule afin de générer un champ magnétique d'excitation des résonances paramétriques, également désigné par champ radiofréquence d'excitation. Dans ce qui suit il sera fait référence à des bobines d'Helmholtz à titre d'exemple desdites bobines 7. Ce circuit d'excitation vient plus particulièrement générer un champ magnétique radiofréquence présentant deux composantes orthogonales à la direction de polarisation et oscillant chacune à sa propre fréquence d'oscillation, à savoir une composante $B_\omega \cos\omega t$ selon l'axe X oscillant à la pulsation $\omega$ et une composante $B_\Omega \cos\Omega t$ selon l'axe Y oscillant à la pulsation $\Omega$. Ces composantes conduisent à des résonances à chacune des fréquences d'oscillation $\Omega/2\pi$, $\omega/2\pi$ et à un inter-harmonique des fréquences d'oscillation $(\omega \pm \Omega)/2\pi$, ces résonances étant associées aux valeurs du champ ambiant dans les directions X, Y et Z respectivement.

Le magnétomètre 20 comprend par ailleurs un photodétecteur 6 agencé pour recevoir le faisceau de lumière ayant traversé la cellule et délivrer un signal électrique représentatif de l'absorption du faisceau de lumière par la cellule ainsi qu'un circuit de détection de résonances paramétriques 9 configuré pour réaliser une détection synchrone à un harmonique de chacune des fréquences d'oscillation du signal électrique délivré par le photodétecteur 6 et une détection synchrone à un inter-harmonique des fréquences d'oscillation du signal électrique délivré par le photodétecteur.

Lorsqu'il est opéré en boucle fermée, le magnétomètre 20 comprend également un circuit d'asservissement 10 du magnétomètre en champ nul. Ce système exploite la sortie du circuit de détection de résonances paramétriques 9 en tant que signal d'erreur pour venir constamment réajuster un champ de compensation. Il comprend un générateur de courant piloté par un signal de compensation dérivé du signal d'erreur pour injecter du courant dans l'une de trois bobines de Helmholtz 7 et générer un champ magnétique de compensation dont les composantes sont opposées à celles du champ ambiant Bx, By, Bz. La mesure des courants circulant dans les bobines 7 permet de déduire le champ de compensation qu'il est nécessaire d'appliquer pour annuler les différentes composantes du champ ambiant, et donc de disposer de la valeur des différentes composantes du champ ambiant. Alternativement, le magnétomètre 20 peut être opéré en boucle ouverte.

Pour démarrer le magnétomètre 20 dans un champ magnétique ambiant qui se situe hors de la zone d'opérabilité donnée par les caractéristiques des signaux de résonances paramétriques en champ nul, l'invention propose de mettre en œuvre une phase de démarrage spécifique qui permet une détermination préalable de ce champ ambiant puis une compensation initiale du champ ambiant ainsi préalablement déterminé, par exemple avec une précision de l'ordre de +/- 100 nT pour un capteur hélium-4.

Comme cela sera détaillé par la suite, cette phase de démarrage permet de déterminer les composantes vectorielles du champ magnétique ambiant dans le repère du capteur en utilisant l'effet Hanle, et ce de manière autonome d'une phase subséquente d'exploitation du capteur pour réaliser une mesure au moyen des résonances paramétriques. Les principes de cette phase de démarrage sont détaillés dans la suite dans le cas d'un magnétomètre « champ nul » à pompage optique de l'hélium-4. Ces principes sont néanmoins tout à fait valables et applicables à l'ensemble des magnétomètres à pompage optique utilisant d'autres éléments sensibles (par exemple des magnétomètres « champ nul » utilisant des gaz d'alcalins). Il est en outre à noter que cette phase de démarrage est fonctionnelle non seulement dans un environnement où le champ magnétique ambiant est statique mais également dans un environnement où le champ magnétique ambiant est variable à la fois en amplitude et en orientation dans le repère du capteur.

Comme indiqué ci-dessus, la phase de démarrage en champ ambiant non nul d'un magnétomètre vectoriel à pompage optique qui utilise nominalement des signaux de résonances paramétriques est basée sur l'exploitation des signaux de résonance Hanle que l'on peut également observer autour de la condition de champ nul. La résonance Hanle est dans ce cas un signal qui se manifeste sur l'absorption du faisceau optique utilisé pour réaliser le pompage optique de l'élément sensible. Pour résumer et simplifier, quand on s'approche de la condition de champ nul, et suivant certaines conditions relatives aux caractéristiques du pompage (la polarisation du faisceau de pompe), la cellule qui renferme l'élément sensible peut être rendue plus « transparente » au faisceau de pompe. C'est-à-dire que l'on va observer dans ces conditions une baisse de l'absorption du faisceau de pompe et donc une augmentation de l'intensité optique détectée après la traversée de la cellule.

La base théorique utilisée par la Demanderesse pour mettre au point la présente invention est celle détaillée dans l'article de Breschi E. et Weis A, « Ground-state Hanle effect based on atomic alignment », Phys. Rev. A 86, 053427, 2012, qui décrit analytiquement l'évolution des signaux de résonance Hanle en fonction du champ magnétique dans le repère du capteur.

Dans le cadre de l'approximation dite à trois étapes, c'est dire une séparation des phénomènes mis en jeu entre le pompage, l'évolution magnétique et la mesure de l'état du système atomique, et en choisissant une polarisation linéaire du faisceau de pompe et l'axe de quantification aligné avec l'axe de la polarisation du faisceau de pompe, on montre dans ce cas que l'évolution de l'absorption $\kappa$ du faisceau de pompe par la cellule renfermant l'élément sensible est au 1er ordre entièrement décrite par celle du terme $m_0^{(2)}$ :

$$\kappa \propto \frac{m_0^{(0)}}{\sqrt{3}} - \sqrt{\frac{2}{3}} m_0^{(2)} \quad (m_0^{(0)} \text{ est ici constant})$$

La puissance optique en sortie de cellule $P_{out}$ est reliée à celle en entrée $P_{in}$ au travers de la loi de Beer-Lambert :

$$P_{out} = P_{in}\, e^{-\kappa L} \approx P_{in}(1 - \kappa L)$$

avec L la longueur du parcours du faisceau dans la cellule, la mesure de son évolution permet de remonter directement à l'évolution du terme $m_0^{(2)}$. On montre que ce terme est maximal en champ nul (on se situe alors sur un minimum d'absorption du faisceau de pompe et donc un maximum de puissance optique $P_{out}$ mesurée en sortie de cellule).

Dans l'article de Breschi E. et Weis A. précité, l'évolution du terme $m_0^{(2)}$ est retranscrite au travers de l'évolution de $m_0^{(2)}$ par rapport à sa valeur en champ nul $m_0^{(2)}{}_{eq}$ via le rapport $\mu_{2,0}$:

$$\mu_{2,0}(B_X, B_Y, B_Z) = \frac{m_0^{(2)}}{m_0^{(2)}{}_{eq}} \quad \text{avec } 0 \leq \mu_{2,0} \leq 1$$

On peut écrire $\mu_{2,0}$ sous la forme :

$$\mu_{2,0}(\beta, \theta) = \left(\frac{3\cos^2\theta - 1}{2}\right)^2 + \frac{3}{4}\frac{\sin^2(2\theta)}{1+\beta^2} + \frac{3}{4}\frac{\sin^4\theta}{1+4\beta^2}$$

Ou bien :

$$\mu_{2,0}(\beta_\parallel, \beta_\perp) = \frac{1}{4} + \frac{3}{4}\frac{16\beta_\parallel^4 + 8\beta_\parallel^2 + 1}{4\beta_\parallel^2 + 4\beta_\perp^2 + 1} - 3\frac{\beta_\parallel^4 + \beta_\parallel^2}{\beta_\parallel^2 + \beta_\perp^2 + 1}$$

Avec comme paramètres, dans le cas par exemple de l'utilisation d'une cellule de gaz d'hélium-4 :

- $\theta$ l'angle entre le champ ambiant $\vec{B}$ et la direction de la polarisation $\vec{E}$ du faisceau de pompe (axe Z)
- 
$$\beta = \frac{\omega}{\Gamma} \text{avec } \Gamma = \Gamma_e + \Gamma_p \text{ et } \omega = \gamma_{He4}B = \gamma_{He4}\sqrt{B_X^2 + B_Y^2 + B_Z^2}$$

- 
$$\beta_\parallel = \frac{\omega_Z}{\Gamma} = \frac{\gamma_{He4}B_Z}{\Gamma} \text{ et } \beta_\perp = \frac{\sqrt{\omega_X^2 + \omega_Y^2}}{\Gamma} = \frac{\gamma_{He4}\sqrt{B_X^2 + B_Y^2}}{\Gamma}$$

- $\gamma_{He4}$, le rapport gyromagnétique de l'état métastable $2^3S_1$ de l'atome d'hélium-4 (28.0238 GHz/T)
- $\Gamma_e$ le taux de relaxation du niveau $2^3S_1$ de l'atome d'hélium-4
- $\Gamma p$ le taux de pompage du niveau $2^3S_1$ vers le niveau $2^3P_0$ de l'atome d'hélium 4

Les signaux de résonance Hanle peuvent ainsi être observés au cours de balayages de champ effectués sur chacun des trois axes du repère du capteur au moyen d'un circuit de génération de champ pouvant être piloté pour générer un champ magnétique dans la cellule. Ce circuit de génération de champ prend par exemple la forme d'un système d'injection de courant dans un ensemble de bobines triaxes placées autour de la cellule, typiquement les bobines de Helmholtz 7 du circuit d'excitation des résonances paramétriques.

Lors de ces balayages, des évolutions de l'intensité lumineuse sont alors observées, par l'intermédiaire de l'évolution du terme $\mu_{2,0}$, sous la forme de courbes lorentziennes résonantes centrées autour des composantes vectorielles du champ ambiant (respectivement -Bx, -By et -Bz) et dont les amplitudes sont liées aux valeurs courantes de $\beta$ et $\theta$.

Par exemple, dans un champ ambiant nul, les signaux de résonance Hanle observés au cours de balayages successifs BaX, BaY et BaZ sur chacun des trois axes du repère capteur présente les formes détaillées sur les figures 4, 5 et 6 respectivement.

En revanche, dans un champ ambiant non nul, par exemple un champ de +50 μT selon l'axe Y du repère capteur, les signaux de résonance Hanle présentent les formes détaillées sur les figures 7, 8 et 9 sur les axes X, Y et Z respectivement.

Les principales caractéristiques des signaux de résonances Hanle que l'on peut déterminer à l'aide de l'article de Breschi E. et Weis A. sont les suivantes :

En champ nul (figures 4-6) :

- On observe des signaux de résonance Hanle au cours de balayages de champ effectués dans le plan XOY (largeur à mi-hauteur autour de 250 nT ici dans le cas d'un capteur hélium-4), ces signaux de résonance sont centrés sur 0 ;
- Aucun signal de résonance n'est observé au cours d'un balayage de champ effectué suivant l'axe Z.

Hors champ nul (figures 7-9) , en simplifiant très grossièrement :

- Au cours de balayages de champ effectués respectivement suivant les axes X et Y du repère instrument :

   o On observe toujours des signaux de résonance Hanle ;
   o L'amplitude des signaux de résonance (centrées sur -Bx et -By) diminue avec les composantes du champ dans le plan XOY mais cet effet peut être contrebalancé par une composante de champ Bz significative suivant l'axe Z ;
   o La largeur des signaux de résonance augmente à la fois avec les composantes du champ dans le plan XOY (Bx, By) et avec Bz ;
   o La présence d'un champ suivant Z introduit des résonances de forme « W » ;

- Au cours d'un balayage de champ effectué suivant l'axe Z:
   o Dès qu'il existe un champ orthogonal à l'axe Z (l'axe de la polarisation rectiligne du faisceau de pompe), des signaux de résonance suivant cet axe apparaissent, centrées sur -Bz, de forme « W » de plus en plus prononcée (largeur et amplitude) à mesure que le champ orthogonal à Z croît.

Sur la base de ces constatations, une procédure de détermination d'une ou des composantes du champ ambiant dans le repère du capteur peut être mise en œuvre lors de la phase de démarrage en effectuant un balayage de champ sur un ou plusieurs des trois axes et en recherchant des points particuliers, tels que des minima d'absorption (maximum de $\mu_{2,0}$ ~ transmission), dans le signal délivré par le photodétecteur.

Afin de mettre en œuvre cette phase de démarrage, et en référence à la figure 3, le magnétomètre 20 est en outre doté d'un circuit de détection de résonances Hanle 11 apte à déterminer au moins une composante du champ magnétique ambiant 10 à partir du signal électrique délivré par le photodétecteur 6 et, couplé audit circuit 11, un circuit de pilotage 12 du circuit de génération de champ (typiquement un circuit de pilotage du courant injecté dans les bobines de Helmholtz 7).

En référence à la figure 10 qui illustre un procédé d'exploitation du magnétomètre, la phase de démarrage ST fait suite à une phase d'initialisation INIT au cours de laquelle l'état atomique de l'élément sensible est préparé au moyen d'une ionisation de la cellule et du pompage accordé sur une transition atomique.

La phase de démarrage ST du magnétomètre 20 est illustré à droite sur la figure 10. Elle comprend une première opération O1 mise en œuvre pour un premier axe desdits trois axes, par exemple l'axe X. Cette première opération O1 comprend les étapes de :

- pilotage, au moyen du circuit de pilotage 12, du circuit de génération de champ (les bobines de Helmholtz 7 typiquement) pour qu'il réalise un balayage de champ BaX suivant le premier axe en venant générer un champ magnétique de recherche suivant le premier axe et moduler (i.e. faire varier) l'amplitude dudit champ magnétique de recherche pour balayer une gamme d'amplitudes ; et de
- détermination DET-Bx, au moyen du circuit de détection de résonances Hanle 11, de la composante Bx du champ magnétique ambiant suivant le premier axe à partir du signal électrique délivré par le photodétecteur au cours du balayage de champ suivant le premier axe.

Suite à la détermination de la composante Bx du champ magnétique ambiant suivant le premier axe, la phase de démarrage peut comprendre une deuxième opération O2 mise en œuvre pour un deuxième axe desdits trois axes, par exemple l'axe Y. Cette deuxième opération O2 comprend le pilotage du circuit de génération de champ pour qu'il génère un premier champ magnétique de compensation COM-Bx opposé à la composante du champ magnétique ambiant suivant le premier axe (compensation de Bx déterminée lors de la première opération O1) et la réitération desdites étapes de pilotage BaY et de détermination DET-By en substituant audit premier axe le deuxième axe desdits trois axes. A l'issue de cette réitération, le champ By suivant l'axe Y est déterminé.

Puis, suite à la détermination de la composante du champ magnétique ambiant suivant le deuxième axe By, la phase de démarrage peut comprendre une troisième opération O3 mise en œuvre pour le troisième axe desdits trois axes, par exemple l'axe Z. Cette troisième opération comprend le pilotage du circuit de génération de champ pour qu'il génère COM-BxBy le premier champ magnétique de compensation (compensation de Bx déterminée lors de la première opération O1) et un deuxième champ magnétique de compensation opposé à la composante du champ magnétique ambiant suivant le deuxième axe (compensation de By déterminée lors de la deuxième opération O2) et la réitération desdites étapes de pilotage BaZ et de détermination DET-Bz en substituant audit deuxième axe le troisième axe desdits trois axes. A l'issue de cette réitération, le champ Bz suivant l'axe Z est déterminé.

A l'issue de la phase de démarrage ST, chacune des composantes Bx, By, Bz du champ ambiant est ainsi connue. Le procédé d'exploitation du magnétomètre se poursuit avec une phase de compensation COMP, au moyen du pilotage du circuit de génération de champ, d'un champ de compensation présentant trois composantes respectivement opposées à chacune des composantes Bx, By, Bz du champ ambiant. Le procédé se poursuit avec une phase d'activation ACT-RP des circuits d'excitation et de détection des résonances paramétriques en champ nul. Le cas échéant, lorsque le magnétomètre est opéré en boucle fermé, le procédé d'exploitation comprend ensuite une phase d'asservissement de champ ASS-BF permettant de maintenir activement le champ nul sur la cellule sur la base des signaux de résonances paramétriques. Le magnétomètre est alors opérationnel et peut, lors d'une phase de mesure MES, procéder à la mesure vectorielle du champ ambiant, par exemple via la connaissance des courants injectés dans les bobines de compensation de champ (compensation statique en boucle ouverte basée sur la compensation réalisée lors de la phase COMP, ou compensation active en boucle fermée basée sur la compensation réalisée lors de la phase d'asservissement ASS-BF).

Des exemples de réalisation préférentiels des opérations O1, O2 et O3 de la phase de démarrage sont présentés ci-après dans lesquels sont réalisés des balayages de champ sur les trois axes qui permettent à la fois d'avoir des signaux de résonances suffisamment contrastés en amplitude et en largeur et des courbes dont la variation de pente est monotone et qui présentent un seul extremum et donc une seule solution pour la recherche du maximum du signal transmis.

Pour cela, les balayages de champ effectués sur chacun des trois axes du repère sonde sont adaptés en y associant quand cela est nécessaire des champs statiques. Cela permet de répondre aux deux contraintes précédentes indépendamment de l'orientation du champ dans le repère du capteur et de son intensité. En pratique, il s'agit de restreindre les valeurs possibles de $\theta$ au cours des différents balayages de champ afin de toujours se situer dans la zone $|\theta| < \theta_f = 54.7\,°$ ou dans la zone $\theta_f < |\theta| \leq 90°$ pour garantir la présence et l'unicité d'extremum au cours des différents balayages de champ réalisés.

Comme cela sera détaillé par la suite, la phase de démarrage peut ainsi en outre comprendre, au cours du balayage de champ suivant le premier axe BaX, le pilotage du circuit de génération de champ pour qu'il génère un champ statique additionnel suivant le troisième axe Z. Le balayage de champ suivant le premier axe BaX peut par ailleurs être réitéré avec un champ statique additionnel suivant le troisième axe de direction opposée.

De manière similaire, la phase de démarrage peut en outre comprendre, au cours du balayage de champ suivant le deuxième axe BaY, le pilotage du circuit de génération de champ pour qu'il génère un champ statique additionnel suivant le troisième axe Z. Et le balayage de champ suivant le deuxième axe BaY peut être réitéré avec un champ statique additionnel suivant le troisième axe de direction opposée.

Et la phase de démarrage peut en outre comprendre, au cours du balayage de champ suivant le troisième axe BaZ, le pilotage du circuit de génération champ pour qu'il génère un champ statique additionnel suivant l'un des premier et deuxième axes.

Un exemple de réalisation de la phase de démarrage ST dans un champ ambiant dont le module est au maximum de 70 $\mu$T est la suivante.

Opération O1

Deux balayages de champ sont successivement mis en œuvre sur l'un des deux axes du plan XOY (le plan orthogonal à l'axe de polarisation rectiligne du faisceau pompe), par exemple sur l'axe X, entre les valeurs minimale et maximale potentiellement possibles du champ ambiant selon cet axe, soit ici entre -70 $\mu$T et + 70 $\mu$T. Ces deux balayages sont réalisés l'un après l'autre avec l'application simultanée d'un champ statique additionnel selon l'axe Z du repère capteur (l'axe Z des bobines de compensation 7 étant aligné suivant l'axe de la polarisation rectiligne du faisceau pompe), soit :

- un premier balayage entre -70 $\mu$T et +70 $\mu$T selon l'axe X avec un champ de +100 $\mu$T appliqué sur l'axe Z ;
- un deuxième balayage entre -70 $\mu$T et +70 $\mu$T selon l'axe X avec un champ de -100 $\mu$T appliqué sur l'axe Z.

L'objectif de ces deux premiers balayages est de déterminer la composante de champ selon l'axe X en détectant le minimum d'absorption centré sur « -Bx » au cours des balayages. L'ajout du champ statique additionnel suivant Z est réalisé afin d'éviter les cas où le champ ambiant serait grossièrement aligné suivant l'axe Y ce qui donnerait un signal de résonance sur l'axe X d'amplitude proche de 0. Le champ additionnel selon Z permet aussi de lever toute indétermination sur le signal de résonance observé au cours des balayages de champ en maintenant la condition $|\theta| < \theta_f = 54.7$° quel que soit le champ ambiant dans le repère de l'instrument.

Opération 02

Une fois la composante de champ Bx déterminée par l'analyse des balayages réalisées sur l'axe X, cette composante de champ est compensée dans le repère du capteur : le champ résultant est alors entièrement localisé dans le plan YOZ. Un balayage de champ de +/- 70 $\mu$T selon l'axe Y est alors réalisé qui permet d'observer un signal de résonance Hanle suffisamment contrasté dont le maximum est centré en « -By ». La composante de champ suivant l'axe Y est alors déterminée par la recherche de ce maximum.

Dans une variante de réalisation plus robuste à certains cas particuliers comme par exemple un démarrage dans lequel le champ ambiant selon Z serait très faible, ce qui peut générer des erreurs de détermination du champ suivant l'axe Y, il est possible à l'image de ce qui est réalisé pour l'axe X, d'effectuer non pas un mais deux balayages suivant l'axe Y :

- un premier balayage suivant Y avec un champ additionnel positif ajouté sur l'axe Z (de l'ordre de quelques largeurs de raies à mi-hauteur des résonances Hanle observées dans les cas les plus résolus) ;
- un seconde balayage de champ suivant Y avec un champ additionnel négatif ajouté sur l'axe Z (toujours de l'ordre de quelques largeurs de raies à mi-hauteur des résonances Hanle observées dans les cas les plus résolus) ;
- la détermination de la valeur du champ selon l'axe Y se faisant par la sélection du maximum de plus forte valeur sur l'ensemble des deux balayages.

Opération 03

La phase de démarrage est poursuivie en compensant les composantes du champ précédemment déterminé dans le repère capteur (Bx et By) et en réalisant un balayage de champ de +/- 70 $\mu$T sur l'axe Z en appliquant cette fois un champ statique additionnel dans le plan XOY (par exemple suivant l'axe X) pour pouvoir observer un signal de résonance suivant cet axe. Pour assurer également l'unicité de la recherche du maximum du signal de résonance au cours du balayage de +/- 70 $\mu$T suivant l'axe Z, ce champ statique additionnel doit maintenir l'angle $\theta$ dans la zone $\theta_f < |\theta| \leq 90$° au cours du balayage. Un champ statique additionnel de 200 $\mu$T est par exemple ajouté sur l'axe X au cours du balayage suivant l'axe Z afin de garantir cette condition et d'assurer également la monotonie de la courbe de résonance observée au cours du balayage sur l'axe Z.

Evidemment, les valeurs numériques et les axes de balayages privilégiés dans le plan XOY sont adaptables en fonction des conditions opératoires du capteur.

La figure 11 détaille l'évolution des signaux de résonance Hanle Rx, Ry et Rz observés au travers de balayages de champ de +/- 70 $\mu$T effectuées sur chacun des axes du repère capteur dans un champ ambiant de [60 ; -10 ; -30] $\mu$T dans le repère capteur dans le cas d'un magnétomètre basé sur le pompage optique d'un gaz d'hélium-4 en alignement.

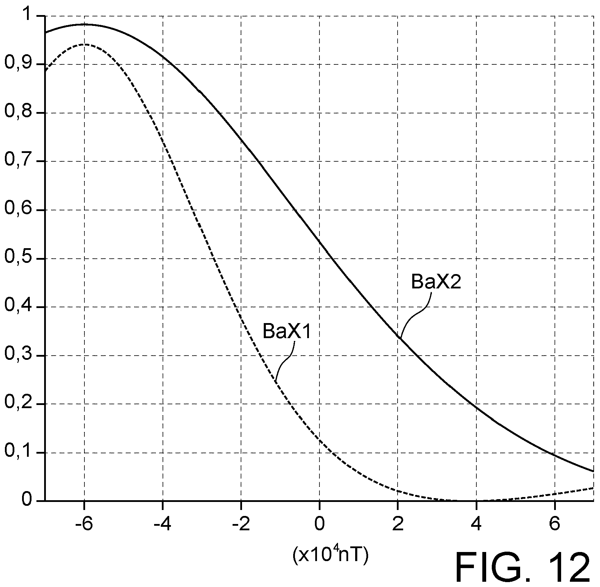

Les figures 12, 13 et 14 détaillent ensuite les évolutions de ces différents signaux au cours des trois opérations de la phase de démarrage selon l'exemple de réalisation précédemment détaillé. Ces figures illustrent la détermination successive des différentes composantes du champ dans le repère capteur qui est réalisée via une recherche de maximum sur l'évolution des différentes courbes.

La figure 12 représente ainsi l'évolution du terme $\mu_{2,0}$ tel que déterminée au cours de la première opération O1 par le signal de résonance Hanle basé sur l'intensité reçue par le photodétecteur au cours des deux balayages de champ BaX1 et BaX2 suivant l'axe X avec respectivement un champ statique de +100 $\mu$T et de -100 $\mu$T sur l'axe Z. La figure 13 représente quant à elle l'évolution du terme $\mu_{2,0}$ au cours du balayage de champ BaY suivant l'axe Y lors de la deuxième opération O2. Et la figure 14 représente l'évolution du terme $\mu_{2,0}$ au cours du balayage de champ BaZ suivant l'axe Z lors de la troisième opération O3, un champ statique de 200 $\mu$T étant appliqué sur l'axe X.

La mise en œuvre pratique de la phase de démarrage précédemment détaillée est susceptible de se heurter à plusieurs obstacles qui vont affecter la précision de détermination des composantes du champ ambiant dans le repère du capteur. On peut mentionner ici des erreurs liées aux caractéristiques de bruit des signaux utilisés dans le processus de détermination, par exemple du bruit optique (bruit d'intensité de la source laser utilisée pour effectuer le pompage, bruit de grenaille du photodétecteur, etc.) ou du bruit de conversion du signal mesuré par le photodétecteur (bruit électronique et numérique de l'étage de conversion analogique/numérique). On peut aussi ajouter des effets liés à l'ensemble de la chaîne fonctionnelle (délais dans les processus des automates/algorithmes, effet de trainage lié aux réponses en fréquence des différents éléments, etc.).

L'ensemble de ces effets sont susceptibles de générer des erreurs dans la détermination des composantes de champ qui peuvent être supérieures à la fenêtre souhaitée de +/- 100 nT lorsque les signaux de résonances Hanle observés ont une largeur à mi-hauteur bien plus importante que 250 nT. Pour aboutir tout de même à la précision requise dans la détermination des composantes vectorielles du champ ambiant, il est alors possible de réaliser une phase de démarrage à plusieurs tours au cours de laquelle on compense petit à petit le champ que l'on détermine, ce qui permet de réduire progressivement les largeurs de raie à mi-hauteur des signaux de résonance observés et de gagner ainsi en sélectivité et en précision de détermination. Cette phase de démarrage à plusieurs tours peut être réalisée de la manière suivante :

- un premier tour est réalisé comme décrit précédemment ;
- un second tour est ensuite réalisé en ayant préalablement compensé les valeurs des composantes de champ déterminées lors du premier tour. Ce second tour est similaire au premier tour mais ne comporte cette fois plus qu'un seul balayage par axe. Les amplitudes des balayages et des champs statiques additionnels sont par ailleurs adaptés à la gamme d'incertitude associée à la détermination réalisée lors du premier tour, tout en veillant à respecter les conditions garantissant la présence et l'unicité des maxima observés lors des balayages (conditions sur $\theta$ par rapport à $\theta_f$ = 54.7°). Il est par exemple possible de réaliser lors de ce second tour :

  o Un premier balayage suivant l'axe X d'amplitude réduite d'un facteur 5 par rapport au premier tour, avec un champ appliqué sur Z également réduit d'un facteur 5 par rapport au premier tour. Ce balayage permet de déterminer la valeur du champ sur l'axe X avec une meilleure précision ;
  o Une compensation du champ suivant l'axe X et un deuxième balayage suivant l'axe Y d'amplitude réduite d'un facteur 5 (amplitude identique au balayage effectué sur l'axe X), avec un champ sur Z identique à celui appliqué lors du balayage sur l'axe X. Ce balayage permet de déterminer la valeur du champ sur l'axe Y avec une meilleure précision ;
  o Une compensation du champ suivant l'axe X et du champ suivant l'axe Y et un troisième balayage sur l'axe Z d'amplitude réduite d'un facteur 5 par rapport au premier tour, et avec un champ appliqué sur X (ou Y) également réduit d'un facteur 5 par rapport au premier tour. Ce balayage permet de déterminer la valeur du champ sur l'axe Z avec une meilleure précision.

Le facteur 5 utilisé ici dans la réduction des différents paramètres d'amplitude des balayages et des champs transverses additionnels est bien entendu purement illustratif, ce facteur pouvant être adapté en fonction des caractéristiques d'erreur sur la détermination des composantes du champ obtenues à la fin du premier tour.

Par ailleurs, si les caractéristiques d'erreur dans la détermination des composantes du champ dans le repère du capteur obtenues à la fin du second tour sont toujours supérieures à la précision recherchée, il est possible de mettre en œuvre autant de tours supplémentaires que nécessaire, chacun réalisé sur le même principe que le second tour en venant progressivement réduire les amplitudes des balayages et des champs additionnels.

L'invention trouve notamment application à la mesure vectorielle du champ magnétique en orbite terrestre ou planétaire, par exemple à la mesure très bas bruit avec une grande bande passante pour l'analyse de signaux rapides dans l'ionosphère (siffleurs, bulles de plasma, courant alignés, météo spatiale, etc.) ou encore à la réalisation de mesures complémentaires destinées à la construction des modèles de champ terrestre (champ de référence géomagnétique international, etc.). L'invention trouve également application à la mesure vectorielle du champ magnétique en aéroporté sur des porteurs mobiles (avions, hélicoptères, drones, etc.) pour de la détection de sources ou de la surveillance de zones par exemple, ainsi qu'à la mesure vectorielle du champ magnétique en lien avec la géophysique et la géologie (prospection minière, pétrolière, observatoires magnétiques, etc.).

**Revendications**

1. Procédé d'exploitation d'un magnétomètre (20) soumis à un champ magnétique ambiant dont la projection sur trois axes de coordonnées rectangulaires en définit trois composantes, le magnétomètre comprenant :

- une source de pompage optique (2, 3) agencée pour émettre en direction d'une cellule (1) remplie d'un gaz atomique un faisceau de lumière accordé sur une transition atomique ;
- un photodétecteur (6) agencé pour détecter le faisceau de lumière ayant traversé la cellule et délivrer un signal électrique représentatif de l'absorption du faisceau de lumière par la cellule ;
- un circuit de génération de champ (7) pouvant être piloté pour générer un champ magnétique dans la cellule ;

le procédé étant **caractérisé par** une phase de démarrage (ST) du magnétomètre qui comprend, pour un premier axe desdits trois axes, les étapes de :

- pilotage du circuit de génération de champ

(i) pour qu'il réalise un balayage de champ suivant le premier axe (BaX) en venant générer un champ magnétique de recherche suivant le premier axe et faire varier l'amplitude dudit champ magnétique de recherche pour balayer une gamme d'amplitudes et

(ii) pour qu'il génère en même temps un champ statique additionnel suivant le troisième axe (Z) afin de garantir une présence et une unicité d'un extremum au cours du balayage de champ réalisé; et de

- détermination de la composante du champ magnétique ambiant suivant le premier axe (DET-Bx) à partir du signal électrique délivré par le photodétecteur au cours du balayage de champ suivant le premier axe.

2. Procédé selon la revendication 1, dans lequel la phase de démarrage comprend, suite à la détermination de la composante du champ magnétique ambiant suivant le premier axe, le pilotage du circuit de génération de champ pour qu'il génère un premier champ magnétique de compensation opposé à la composante du champ magnétique ambiant suivant le premier axe (COM-Bx) et la réitération desdites étapes de pilotage et de détermination (BaY, DET-By) en substituant audit premier axe un deuxième axe desdits trois axes.

3. Procédé selon la revendication 2, dans lequel la phase de démarrage comprend, suite à la détermination de la composante du champ magnétique ambiant suivant le deuxième axe, le pilotage du circuit de génération de champ pour qu'il génère le premier champ magnétique de compensation et un deuxième champ magnétique de compensation opposé à la composante du champ magnétique ambiant suivant le deuxième axe (COM-BxBy) et la réitération desdites étapes de pilotage et de détermination (BaZ, DET-Bz) en substituant audit deuxième axe un troisième axe desdits trois axes.

4. Procédé selon la revendication 3, dans lequel le balayage de champ suivant le premier axe est réitéré avec un champ statique additionnel suivant le troisième axe de direction opposée.

5. Procédé selonla revendication 3, dans lequel la phase de démarrage comprend en outre, au cours du balayage de champ suivant le deuxième axe (BaY), le pilotage du circuit de génération de champ pour qu'il génère un champ statique additionnel suivant le troisième axe.

6. Procédé selon la revendication 5, dans lequel le balayage de champ suivant le deuxième axe est réitéré avec un champ statique additionnel suivant le troisième axe de direction opposée.

7. Procédé selon la revendication 3, dans lequel la phase de démarrage comprend en outre, au cours du balayage de champ suivant le troisième axe (BaZ), le pilotage du circuit de génération de champ pour qu'il génère un champ statique additionnel suivant l'un des premier et deuxième axes.

8. Procédé selon l'une des revendications 3 à 7, dans lequel la phase de démarrage (ST) comprend en outre, suite à la détermination de la composante du champ magnétique ambiant selon le troisième axe, une étape de pilotage du circuit de génération de champ pour qu'il génère ledit premier champ magnétique de compensation, ledit deuxième champ magnétique de compensation et un troisième champ magnétique de compensation opposé à la composante du champ magnétique ambiant suivant le troisième axe (COMP).

9. Procédé selon la revendication 8, comprenant à l'issue de la phase de démarrage une phase de fonctionnement au cours de laquelle le circuit de génération de champ est asservi par un circuit de détection de résonances paramétriques pour assurer un fonctionnement en champ nul du magnétomètre (ASS-BF).

10. Magnétomètre (20) destiné à la mesure d'un champ magnétique ambiant dont la projection sur trois axes de coordonnées rectangulaires en définit trois composantes, comprenant :

- une source de pompage optique (2, 3) agencée pour émettre en direction d'une cellule remplie d'un gaz atomique un faisceau de lumière accordé sur une transition atomique ;
- un photodétecteur (6) agencé pour recevoir le faisceau de lumière ayant traversé la cellule et configuré pour délivrer un signal électrique représentatif de l'absorption du faisceau de lumière par la cellule ;
- un circuit de génération de champ (7) apte à être piloté pour générer un champ magnétique dans la cellule ;

**caractérisé en ce qu'**il comporte en outre :

- un circuit de pilotage (12) du circuit de génération de champ, ledit circuit de pilotage étant configuré

(i) pour que le circuit de génération de champ réalise un premier balayage de champ (BaX) en venant générer un champ magnétique de recherche selon un premier axe desdits trois axes et faire varier l'amplitude dudit champ magnétique de recherche pour balayer une première gamme d'amplitudes et
(ii) pour que le circuit de génération de champ génère en même temps un champ statique additionnel suivant le troisième axe (Z) afin de garantir une présence et une unicité d'un extremum au cours du balayage de champ réalisé;

- un circuit de détermination (12) d'une composante du champ magnétique ambiant selon le premier axe à partir du signal électrique délivré par le photodétecteur au cours du premier balayage de champ.

FIG. 1

EP 4 075 156 A1

FIG. 2

FIG. 3

20

1 2 3 4 5 6 7 8 9 10 11 12

X Y Z

FIG. 4

FIG. 5

FIG. 6

EP 4 075 156 A1

FIG. 7

FIG. 8

FIG. 9

EP 4 075 156 A1

O1

BaX
DET-Bx

O2

COM-Bx
BaY
DET-By

O3

COM-BxBy
BaZ
DET-Bz

INIT
ST
COMP
ACT-RP
ASS-BF
MES

FIG. 10

FIG. 11

(x10$^4$nT)

FIG. 12

(x10$^4$nT)

FIG. 13

EP 4 075 156 A1

FIG. 14

Europäisches
Patentamt

European
Patent Office

Office européen
des brevets

# RAPPORT DE RECHERCHE EUROPEENNE

Numéro de la demande

EP 22 16 7193

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2020/072916 A1 (ALFORD JAMU [US] ET AL) 5 mars 2020 (2020-03-05) | 1-5,7-10 | INV.<br>G01R33/032 |
| A | * alinéas [0005], [0067], [0087] – [0092]; figures 4-6 * | 6 | G01R33/00 |
| A | US 2020/292639 A1 (LE PRADO MATTHIEU [FR] ET AL) 17 septembre 2020 (2020-09-17) * alinéas [0010], [0011], [0021], [0027] – [0036]; figure 1 * | 1-10 | |
| A | US 2016/084925 A1 (LE PRADO MATTHIEU [FR] ET AL) 24 mars 2016 (2016-03-24) * alinéas [0031] – [0064] * | 1-10 | |
| A | EP 3 370 077 B1 (COMMISSARIAT ENERGIE ATOMIQUE [FR]) 31 juillet 2019 (2019-07-31) * alinéas [0001], [0003], [0017], [0018], [0021] – [0025], [0033] – [0037]; figures 1-3 * | 1-10 | |
| A | US 2020/150196 A1 (BEATO FRANÇOIS [FR] ET AL) 14 mai 2020 (2020-05-14) * alinéas [0003], [0009], [0038], [0045], [0046], [0053], [0055]; figure 1 * | 5-7 | DOMAINES TECHNIQUES RECHERCHES (IPC)<br><br>G01R |
| A | US 2020/018802 A1 (PALACIOS LALOY AUGUSTIN [FR] ET AL) 16 janvier 2020 (2020-01-16) * alinéas [0002], [0010], [0049] – [0052], [0065]; figure 1 * | 5-7,10 | |
| A | FR 2 779 530 A1 (COMMISSARIAT ENERGIE ATOMIQUE [FR]) 10 décembre 1999 (1999-12-10) * pages 2-4; figure 1 * | 1-3 | |

Le présent rapport a été établi pour toutes les revendications

| Lieu de la recherche | Date d'achèvement de la recherche | Examinateur |
|---|---|---|
| Munich | 8 août 2022 | Loughman, John |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
.................................................................
& : membre de la même famille, document correspondant

EPO FORM 1503 03.82 (P04C02)

**ANNEXE AU RAPPORT DE RECHERCHE EUROPEENNE**
**RELATIF A LA DEMANDE DE BREVET EUROPEEN NO.**

EP 22 16 7193

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

08-08-2022

| Document brevet cité au rapport de recherche | Date de publication | Membre(s) de la famille de brevet(s) | Date de publication |
|---|---|---|---|
| US 2020072916 A1 | 05-03-2020 | EP 3814792 A1 | 05-05-2021 |
| | | US 2020072916 A1 | 05-03-2020 |
| | | US 2020209328 A1 | 02-07-2020 |
| | | US 2021080522 A1 | 18-03-2021 |
| | | WO 2020046433 A1 | 05-03-2020 |
| US 2020292639 A1 | 17-09-2020 | EP 3730959 A1 | 28-10-2020 |
| | | FR 3093816 A1 | 18-09-2020 |
| | | US 2020292639 A1 | 17-09-2020 |
| US 2016084925 A1 | 24-03-2016 | EP 2998758 A2 | 23-03-2016 |
| | | FR 3026193 A1 | 25-03-2016 |
| | | US 2016084925 A1 | 24-03-2016 |
| EP 3370077 B1 | 31-07-2019 | EP 3370077 A1 | 05-09-2018 |
| | | FR 3063547 A1 | 07-09-2018 |
| US 2020150196 A1 | 14-05-2020 | EP 3650877 A1 | 13-05-2020 |
| | | FR 3088441 A1 | 15-05-2020 |
| | | US 2020150196 A1 | 14-05-2020 |
| US 2020018802 A1 | 16-01-2020 | EP 3598157 A1 | 22-01-2020 |
| | | FR 3083876 A1 | 17-01-2020 |
| | | US 2020018802 A1 | 16-01-2020 |
| FR 2779530 A1 | 10-12-1999 | CA 2274623 A1 | 09-12-1999 |
| | | EP 0964260 A1 | 15-12-1999 |
| | | FR 2779530 A1 | 10-12-1999 |
| | | US 6313628 B1 | 06-11-2001 |

EPO FORM P0460

Pour tout renseignement concernant cette annexe : voir Journal Officiel de l'Office européen des brevets, No.12/82

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 3093816 A1

**Littérature non-brevet citée dans la description**

- **BRESCHI E ; WEIS A.** Ground-state Hanle effect based on atomic alignment. *Phys. Rev.,* 2012, vol. 86, 053427